# EUROPEAN PATENT SPECIFICATION

(11) **EP 1 387 901 B1**
(45) Date of publication and mention of the grant of the patent: **31.10.2007**
(21) Application number: 02736461.1
(22) Date of filing: 03.05.2002
(51) Int. Cl.: D06B 19/00, D06M 10/02

(54) **METHOD AND APPARATUS FOR TREATMENTS OF TEXTILE MATERIALS**
VERFAHREN UND VORRICHTUNG ZUR BEHANDLUNG VON TEXTILMATERIALIEN
PROCEDE ET APPAREIL DE TRAITEMENT DE MATERIAUX TEXTILES

(30) Priority: 04.05.2001 SK 629012001
(43) Date of publication of application: 11.02.2004
(73) Proprietor: Cernak, Mirko, 847 01 Bratislava (SK)
(72) Inventor: Cernak, Mirko, 847 01 Bratislava (SK)
(74) Representative: Danek, Vilém
(86) International application number: PCT/SK2002/000008
(87) International publication number: WO 2002/095115

(56) References cited:
- EP-A- 0 467 639
- US-A- 5 407 639
- US-A- 5 792 517
- PATENT ABSTRACTS OF JAPAN vol. 1998, no. 9, 31 July 1998 (1998-07-31) -& JP 10 087857 A (JAPAN VILENE CO. LTD.), 7 April 1998 (1998-04-07) cited in the application
- V.I. GIBALOV; G.J. PIETSCH: "The development of dielectric barrier discharges in gas gaps and on surfaces" JOURNAL OF PHYSICS D: APPLIED PHYSICS, vol. 33, 2000, pages 2618-2636, XP001086471 IOP PUBLISHING, BRISTOL, GB ISSN: 0022-3727 cited in the application

## Description

### Technical field

The invention relates to a method and apparatus for treatment of inner and outer surfaces of woven and nonwoven textiles and cords from organic and inorganic fibres with the aim to change surface properties of the fibres as, first of all, hydrophilicity, hydrophobicity, surface energy, adhesion to other materials, colourability, surface electrical conductivity, and biocompactibility.

### Background Art

Textiles are made from organic or inorganic fibres that often do not possesses the surface properties needed for given applications as, for example, hydrophilicity, hydrophobicity, surface energy, adhesion to other materials, dyeability, surface electrical conductivity, andbiocompactibility. The surface properties of fibres situated inside of the textile material or on the outer textile material surfaces can be modified by various chemical methods described in, for example, F. Baldwin:"The chemical finishing of nonwovens INDA-TEC 97,6.0-6.42, as well as in patent applications DE 19,647,458; WO 97/11989; JP 09241980 ; and JP09158020. These methods are based on the use of aggressive chemicals as, for example,NaOH, SO2 fluorine, chlorine, H2O2, and toxic chemicals as, for example, blockedisocyanates and xylene. An environmentally more acceptable option is the use of surfactant-based finishes, such as described in WO 98/03717, which are applied mainly through topical treatments such as spraying, coating, padding, etc. A major problem encountered with these methods is that the coating is not usually well-bonded to the fibre and may be partially lost during storage or in subsequent operations.

It has been found that plasmachemical treatment methods can overcome these difficulties since they are more versatile and do not need the use of aggressive chemical, toxic and volatile organic solvents. The plasmachemical methods are based on the use of low temperature electrical plasmas.

The low temperature plasmas as described herein, are partially ionised and consist of activated species including gas molecules, ions, electrons, free radicals, metastables, and photons in short wave ultraviolet range. While the gas temperature is low, the electrons have energies of several electron volts, corresponding to the temperatures on the order of 104 K. The electrons in collisions with gas molecules generate excited gas species, which can react with a variety of substrates to achieve modifications of surface properties. Such plasmas, plasmachemical methods, and apparatus for performing such methods to treat nonwoven textiles are reviewed in W. Ralcowski :2nd TANDEC Conf. (1992), D. Zhang et al.: Polym. Eng. Sci, 38 (1998) 965-70 and to treat woven textiles in M. Sotton, G. Nemoz: J. Coat. Fabrics 24 (1994) 138.
The disadvantage of the plasmachemical methods disclosed in patents WO 00/16914, WO 00/16914, WO 96/27044, GB 2098636, US 6,118,218, US 6,103,068, US 6,096,156, US 5,501,880, US 5,376,413, US 5,328,576, US 5,053,246, US 4,479,369, JP 11256476, JP 10325078, JP 09330672, JP06310117, JP 05287676 is that the low-temperature electrical plasmas are generated at low gas pressures thereby making the plasma equipment expensive and continuos operation difficult. Moreover, to generate a low-pressure plasma inside of a textile to treat the inner textile surfaces, an average fabric pore size must be larger than is the distance over which a charge imbalance (Debye length) can exist. This, however, is for the pore size on the order of 10-100 microns fulfilled only at near-atmospheric pressures.

For almost two decades, examples of atmospheric pressure non-equilibrium plasmas have been entering the literature, including the examples where atmospheric pressure plasmas are used to treat textile materials. The atmospheric pressure level operation is employed for high throughput and reduced capital cost since batch processing of textiles and vacuum pumping equipment are not necessary. Such atmospheric-pressure plasmachemical methods and corresponding apparatus, where the low-temperature plasmas are generated in so-called volume barrier electrical discharges, are disclosed in patents JP 11329669, JP 11253484, JP 11217766, JP 10273874, JP 08337675, JP 07119021, JP06119994, US 5,830,810, US 5,766,425, US 5,688,465 and US Patent Application 20010008733. The volume barrier discharge was generated by applying a high frequency, high voltage signal to an electrode separated from an earthen plane or cylinder by a discharge gap and a dielectric barrier. The fabric treated is localised on the dielectric barrier surface between both electrodes. The main drawback of such volume barrier discharge devices used for textile treatment is that the useful plasma conditions are achieved only in small volume plasma channels termed"streamers"developing perpendicularly to the textile fibres. As a consequence, the plasma is in a very limited contact with the textile fibre surfaces, which results in nonuniform treatment and long treatment times.

The technological developments have it now made possible to construct atmospheric-pressure plasma apparatus operating in a glow discharge mode, i. e., with a homogenous volumetric plasma structure without the streamers, which are similar to that of low pressure plasmas. Applications of such plasma apparatus for textile treatment, where the treated textile is localised between the discharge electrodes, are disclosed in patents JP 08311765, US 5,118,218, US 6,106,659, US 5,895,558, US 5,585,147, US 5,529,631, and US 5,456,972. Nevertheless, the discharge stability, in particular in air and other reactive gases, has continued to be a vexing problem preventing such apparatus from becoming commercial successes.

JP 10241827 and JP 10139947 disclose the atmospheric-pressure plasma apparatus for the treatment of textiles and fibres energised by fast-rising high-voltage pulses, where the treated material is localised between the electrodes. Besides apparent safety and electromagnetic interference problems, such energisation is technically and economically problematic.

In atmospheric-pressure plasmachemical methods and apparatus for the textile treatments described in patents JP 11354093, JP 11348036, JP 11335963, JP 11333225, JP 11102685, JP 11003694, JP 09007444, JP 08124578, WO98/52240, WO 96/15306, US 5,834,384, US 5,821,178,US 4,466,258, EP 903794, EP 0483859, and EP 0730057 the low-temperature plasma is generated in corona discharges without a dielectric barrier between the discharge electrodes. The treated textile materials are situated between the electrodes. The use of such corona discharges for the textile treatment is, however, unsatisfactory because of their low power density and resulting long treatment times.

An atmospheric-pressure plasmachemical method for the treatment of skin surface of textile materials is disclosed in patent JP 100087857. The device described there differs from the volume barrier discharge devices chiefly in that the streamers are parallel with the fabric surface, and the discharge electrodes are situated on the same side of the treated textile material. In this way, using a surface barrier discharge, the plasma is in a better contact with the surface, which reduces the treatment time significantly. The patent discloses the treatment of a thin skin layer of the textile only, and the described method does not effect the properties of the surfaces of the textile materials.

The use of an optimised apparatus with the same electrode arrangement as in patent JP 100087857 for the textile treatment including the inner textile surface treatment is described, for example, in M. Cernak et al.: Prof. 17th Symp. On Plasma Processing, Nagasaki 2000, pp.535-8, M. Cernak et al.: Abstracts of 7th Int.Conf. on Plasma Surface Engineering,Garmisch-Partenkirchen 2000, p. 86, and J. Rahel, M.Cernak, 1. Hudec, A.Brablec, D. Trunec:"Atmospheric-pressure plasma treatment of ultra-light-molecular-weight polypropylene fabric"Czech. J. Phys. 50 (2000), Suppl.53, 445-48. An apparent disadvantage of such surface barrier discharges for potential industrial use is the limited lifetime of their electrode system due to a direct contact of the discharge plasma with metallic electrode surfaces and resulting electrode surface erosion. The electrode lifetime can be limited also by an abrasion at the metallic electrode-textile surface.

The electrode surface erosion and abrasion is eliminated in apparatus, where the coplanar surface discharge is used. The coplanar surface discharge is described, for example, in A. Sato et al.: IEEE Trans. Electron Devices 23 (1976) 328, M. Haacke and G. J. Pietch: Proc. of XII Int. Conf. on Gas Discharges and their Appl., Glagow, Sept. 2000, p. 267, V. I. Gibalov, G. J.Pietsch : J. Phys. D: Appl. Phys. 33 (2000)2618, and E. H. Choi at al.: Jpn. J. Appl. Phys. 38 (1999) 6073. In the coplanar surface discharge defined in these references the electrodes are situated inside of a dielectric body and, consequently, the discharge plasma is not in contact with metallic electrodes. The coplanar discharges are widely used in AC plasma displays as described, for example, in US 4,039,881 and US 3,964,050. Patents JP 5810559 and US 4,783,716 describe the coplanar surface discharges used as a source of ions for charging and discharging of dielectric surfaces. Patent JP 1246104 describes the coplanar surface discharge used for ozone production. Patent JP 3190077 describes the apparatus for ozone production where besides the main electrodes embedded in the dielectric body an auxiliary electrode situated on the dielectric body surface is used to generate a coplanar surface discharge. Such a surface auxiliary electrode has the disadvantage of its limited life time due to an interaction with the discharge plasma. Patent US 5,407,639 describes the auxiliary electrode of a coplanar surface discharge electrode system, which is embedded in the dielectric body. The aim of such a electrode is to initiate the discharge at reduced voltage values and increase its power for ozone production.

The present invention related to the use of the known coplanar surface discharge for treatment of inner and outer surfaces of woven and nonwoven textiles and cords from organic and inorganic fibres.

### Disclosure of Invention

It is the primary object of the present invention to provide a method and apparatus for treatment of internal and outer surfaces of woven and nonwoven textiles and cords from organic and inorganic fibres with the aim to change surface properties of the fibres by the action of electrical plasma. The electrical plasma is produced by electrical discharges generated using a discharge electrode system that comprises of at least two electrically conductive electrodes situated on the same side of the treated textile material inside of a dielectric body. The electrodes are energised by electrical voltage at a frequency from 50 Hz to 1 MHz and magnitude from 100 V to 100 kV, and the electrical discharges take place in a working gas at a pressure ranging from 1kPa to 1 000 kPa above a part of the dielectric body surface, wherein the plasma is generated without a contact with the conductive electrodes.

According to the preferred embodiment of the invention, the conductive electrodes are situated in parallel with the part of the dielectric body surface above that the plasma is generated.

According to another preferred embodiment of the invention, the part of the dielectric body surface above that the plasma is generated has the shape of a given pattern.

According to another preferred embodiment of the invention, the apparatus comprises of the electrode system consisting of at least two electrically conductive electrodes, which are situated inside of a dielectric body, and an auxiliary system of electrodes also situated inside of the dielectric body.

In a preferred embodiment of the invention the electrode systems are situated on both sides of the treated textile material. According to another embodiment of the invention, the part of the dielectric body surface above that the plasma is generated has the shape of a plane surface, curved surface, or cylindrical surface.

According to another embodiment of the invention, a part of the dielectric body inside of that the electrodes are situated is made from a ferroelectric or liquid dielectric material.

According to a preferred embodiment of the invention the electrode edges are curved.

According to another embodiment of the invention a part of the dielectric body inside of that the electrodes are situated contains MgO.

According to the present invention, the electrical plasma is generated by electrical discharges in the vicinity of the dielectric body surface, wherein a part of the dielectric body insulating the electrodes each from other as well as from the electrical plasma is made preferably from a ferroelectric material. The treated textile material is situated on the part of the dielectric body surface above that the plasma is generated, or is in motion along the part of the dielectric body surface above that the plasma is generated, in a direct contact with this surface, or in close vicinity of this surface, in such a way that the discharge electrodes of the electrode system are embedded inside the dielectric body on the same side of the treated textile material. Such an electrode arrangement is characterised by the fact that all or the majority of electrical field lines enter and go out from the treated textile on the same side of the treated textile and by the fact that the discharge electrodes are not in a contact with the electrical plasma. As a consequence, the electric field lines and the electrical discharge channels have the direction mostly parallel with the textile fibre surfaces and the electrode lifetime is not reduced by oxidation or erosion due to a contact with the plasma, and due to the abrasion by the treated textile. An alternating or pulsed electrical voltage of a magnitude ranging from 100 V to 100 kV and a frequency ranging from 50 Hz to 1 MHz is applied between the discharge electrodes serving to the discharge generation. The apparatus can operate over a wide pressure range from on the order of 1 kPa to the order of 1000 kPa, preferably at atmospheric gas pressure.

### Brief Description of Drawings

FIG.1 is a schematic cross-sectional view illustrating a part of the planar electrode system for the surface discharge generation that can be an essential part of the apparatus schematically illustrated by Fig. 3 and Fig. 4.
FIG. 2 is a schematic cross-sectional view illustrating a part of the electrode system with a cylindrical surface shape, which is equipped with an auxiliary electrode structure and can be a substantial part of the apparatus illustrated in Fig.5.
FIG. 3 is a side sectional view schematically illustrating the apparatus aimed to treat textile materials from one side, where the treated textile material is moved along the planar electrode system shown schematically in Fig.1
FIG. 4 is a side sectional view of the apparatus aimed to treat textile materials from both sides, where the treated textile material is moved between two electrode systems as that one illustrated schematically in Fig. 1.
FIG. 5. is a side sectional view of the device, where the treated textile material is in brought into close contact with the cylindrical surface of the electrode system that is illustrated schematically in Fig. 2.

### Best Mode for Carrying Out the Invention

### Examples

### Example 1

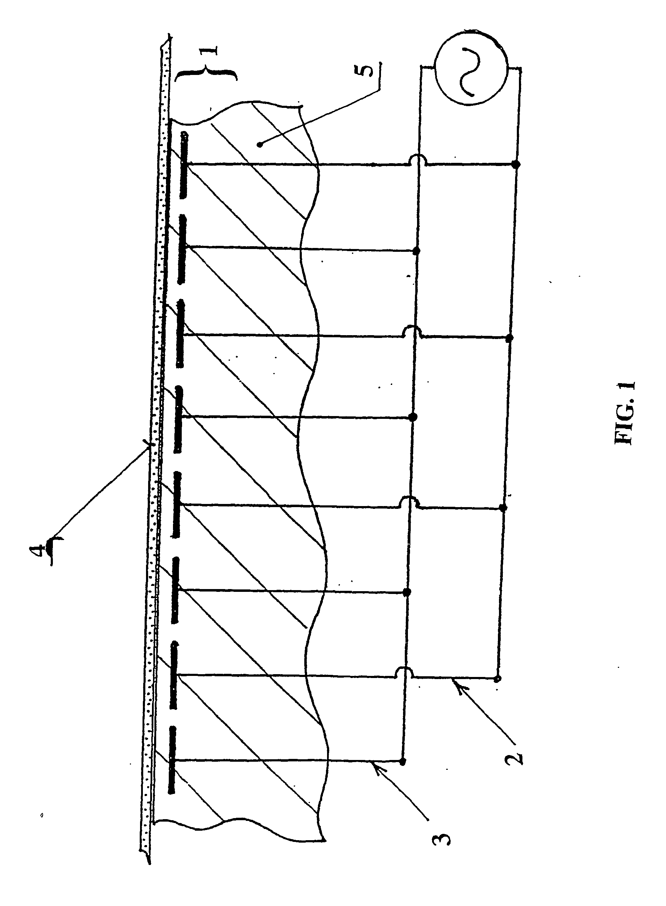

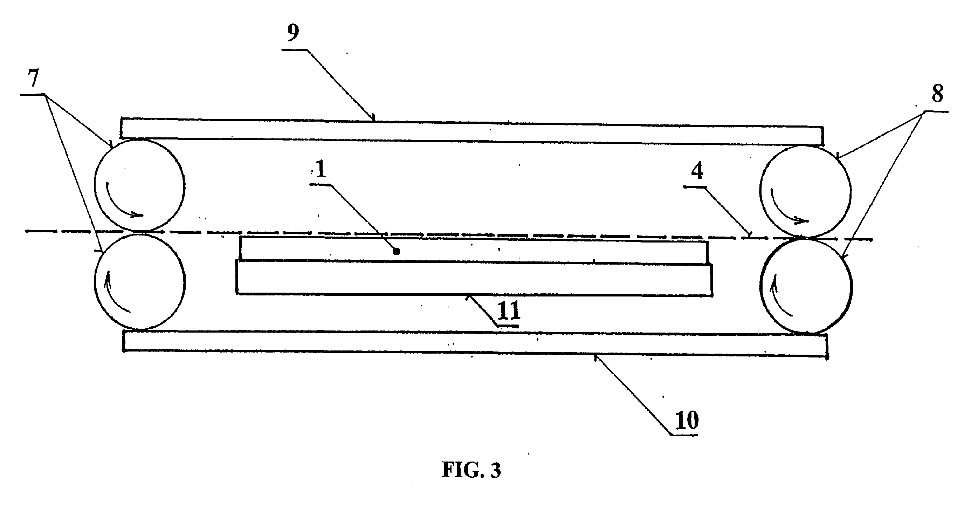

In the device used for the surface treatment of textile materials from one side, which is illustrated by FIG.1, the treated textile material 4 was moved continuously on the surface of the electrode system 1. The electrode system 1 is in detail illustrated in FIG.1. The textile material 4 was moved by means of two pairs of rolls 7 and 8 (see Fig.3). The space between both pairs of rollers was sealed by an upper wall9, bottom wall 10, and by side walls that are not shown. A working gas with a pressure a little above the atmospheric pressure was fed into the sealed space. An electrical plasma was generated in the working gas on the surface of the electrode system 1. The electrode system 1 was situated on the surface of a cooler 11.

The planar electrode system 1 illustrated by FIG. 3 and shown in detail in FIG.1, which was used to generate surface electrical discharges, comprised of two coplanar electrodes 2 and 3 having the shape of a system of 2-mm-wide parallel strips. The distance between the strips of both electrodes2 and 3 was 0.5 mm. The dielectric body 5 shown in FIG.1 comprised of a 0. 5-mm-thick A1203 layer with the coplanar metallic electrodes 2 and 3 deposited by vacuum sputtering and subsequent electroplating on its bottom surface and of a solid dielectric layer coating the A1203 layer and electrodes 2 and 3 from their bottom side. An alternating electrical voltage of was applied between the electrodes 2 and 3. The frequency of the voltage was 25 *kHz* and the voltage was 10 kV peak-to-peak.

### Example 2.

A non-woven polypropylene textile(spunbond, 15g/m2, 2.8-3.2 dtex) was treated according to the invention. The aim was to impart hydrophilicity to fiber surfaces in whole volume of the textile and, consequently, to improve perviousness of the textile for water, urine, and other liquids. The non-woven fabric was treated by the plasma generated in nitrogen using the device described in Example 1. The strike-through time of test liquid through the textile was measured using a standard ETR 150.3-96 method. The exposure time of 0.8 s resulted in a 30-fold reduction in the strikethrough time.

### Example 3

The method according to the present invention was used for a hydrophilic treatment of biodegradable PLA textile of square weight of 15g/m2. The aim of the treatment was to impart hydrophilicity to fibre surfaces in whole volume of the textile and, consequently, to improve perviousness of the textile for water, urine, and other liquids. The textile was treated using the apparatus described in Example 1 in the CO2 plasma. The exposure time of 1.2 s resulted in the permanent strike-through time value of 3 s.

### Example 4

The method according to the present invention was used for hydrophilic treatment of a nonwoven polypropylene textile (spunbond, 18g/m2, 2.8-3.2 dtex). The aim was to impart the hydrophilicity to a portion of the textile in the shape of a given pattern for the application in baby diapers manufacturing. Using the apparatus described in Example 1, wherein the portion of the surface of the dielectric body 5 under that the electrodes 2 and 3 were situated had the shape of a given pattern, and the textile movement was interrupted for a treatment time of two seconds. The 2 s treatment resulted in a 30-fold reduction in the strike-through time on the treated textile portion, whereas the rest of the textile remained hydrophobic.

### Example 5

The method according to the present invention was used for surface activation of a woven textile material made from E-glass (210g/m2, 0.18 mm thick) for the use as a reinforcement in composite materials. The textile was treated in a mixture of nitrogen and water vapour at 80°C.

When compared with a conventional thermal activation method, a treatment time of five seconds resulted in a fivefold higher density of surface OH groups measured by the ESCA method.

### Example 6

The method according to the present invention was used for surface activation of a thin skin layer of a thick (200 g/m2) PP meltblown nonwoven textile with the aim to increase textile surface energy and its adhesive properties for the following lamination. A 2 s exposition of the textile to the plasma generated in nitrogen with 3%-admixture of hydrogen resulted in an increase of the surface energy from 30 N/m for the untreated textile to 72 N/m for the plasma-treated textile, and the adhesive properties were improved significantly.

### Example 7

In the apparatus illustrated in FIG. 3, which was used for a treatment of the textile in the shape of given surface pattern, the treated textile 4 was moved intermittently on the surface of the planar electrode system 1. The textile was moved intermittently for the length of the electrode system 1 in a one movement cycle using two pairs of guide rolls 7 and8. The space between both pairs of rollers was sealed by an upper wall 9, bottom wall 10, and by side walls that are not shown.

A working gas with a pressure a little above the atmospheric pressure was fed into the sealed space.

An electrical plasma was generated in the working gas on the surface of the electrode system 1. The planar electrode system1 illustrated by FIG. 3 and shown in detail in FIG.1, which was used to generate surface electrical discharges, comprised of two coplanar electrodes 2 and 3 having the shape of a system of 1-mm-wide parallel strips. The distance between the strips of both electrodes 2 and 3 was 0.5 mm. The dielectric body 5 shown in FIG.I comprised of a 0.25-mm-thick A1203 layer with the coplanar metallic electrodes 2 and 3 deposited by vacuum sputtering and subsequent electroplating on its bottom surface and of a solid dielectric layer coating the Al203 layer and electrodes2 and 3 from their bottom side. The electrode system 1 was situated on the surface of a cooler11. An alternating electrical voltage of was applied between the electrodes 2 and3. The frequency of the voltage was 5 kHz and the voltage was 5 kV peak-to-peak. From a plan view in the direction perpendicular to the electrode system 1 surface, the electrodes 2 and 3 covered the electrode system surface portion corresponding to the shape of a given pattern, where a thin plasma layer was generated in the shape of the given pattern.

### Example 8

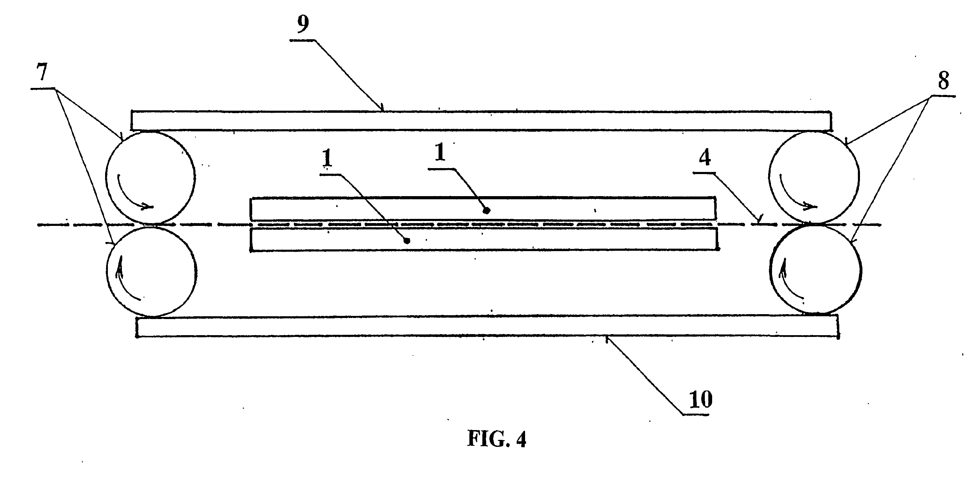

The device illustrated in FIG. 4 was used for the textile treatment by plasma from both sides of the treated textile. The treated textile 4 was moved between two planar electrode systems 1. The electrode system1 is in detail illustrated by FIG. 1. The electrode systems 1 used were identical with the electrode system 1 described in Example 1. The treated textile 4 was moved by means of two pairs of rolls 7 and 8. The space between both pairs of rollers was sealed by an upper wall9, bottom wall 10, and by side walls that are not shown. A working gas with a pressure a little above the atmospheric pressure was fed into the sealed space. An electrical plasma was generated in the working gas on the surface of the electrode system 1.

### Example 9

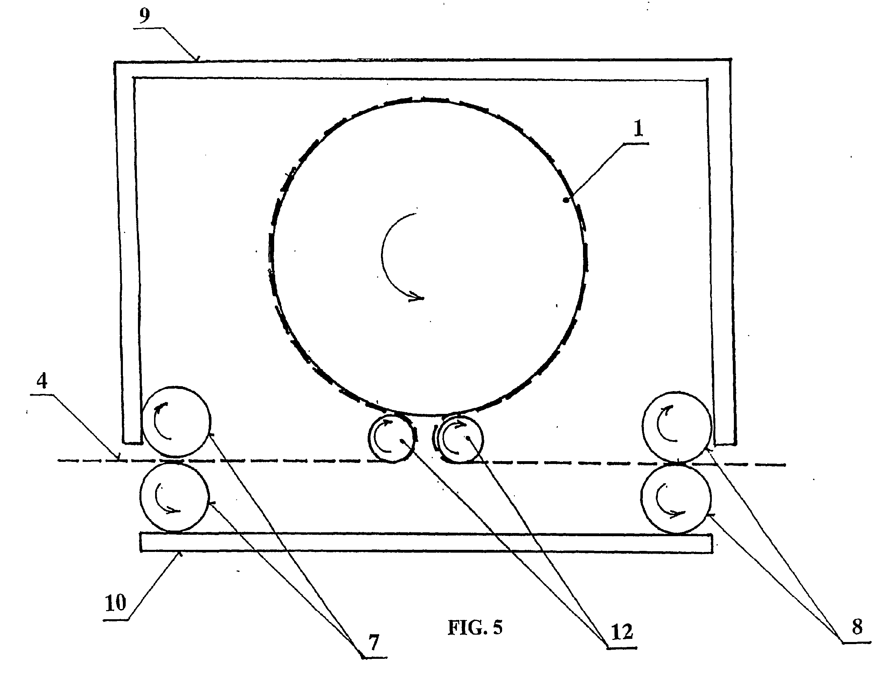

In the apparatus according to the present invention, which is illustrated in FIG.5, the electrode system 1 has the shape of a cylinder envelope. The treaded textile 4 was fed into and out of the apparatus by means of two pairs of rolls 7 and 8. Inside of the device, the treated textile 4 was brought on the surface of the electrode system 1 by means of pair of internal guide rolls 12. The space between the pairs of rolls 7 and 8 was sealed by an upper wall 9, bottom wall 10, and by side walls that are not shown. A working gas with a pressure a little above the atmospheric pressure was fed into the sealed space. An electrical plasma was generated in the working gas on the surface of the electrode system 1.

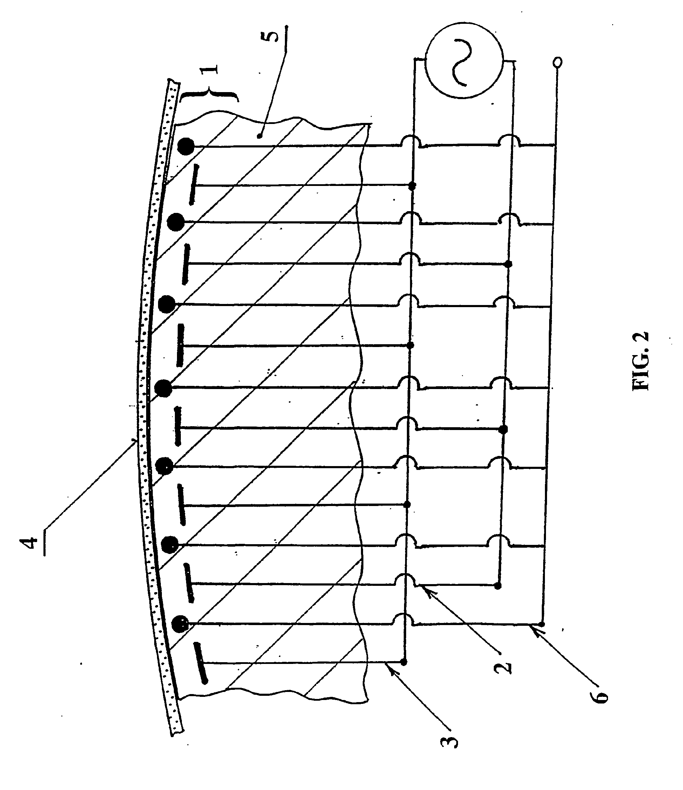

The outer part of electrode system 1 having the shape of a cylinder envelope, which is shown in detail in FIG. 2, was made from a 1-mm-thick glaze layer. The glaze layer was deposited on the surface of a cooled ceramic cylinder and coplanar metallic electrodes 2 and 3, having the shape of a system of 1-mm-wide parallel strips with the distance between the strips of 0.5 mm, were embedded in it. The auxiliary electrode structure 11 was situated symmetrically between the electrodes 2 and 3 in such a way that the distance between the auxiliary electrode structure 11 surface and the surface of the electrode system 1 was 0.25 mm. The auxiliary electrode structure 11 was made from 0.5-mm-diam. metallic wires. The cylinder with the electrode system 1 on its surface rotated and carried the treated textile 4 on its surface. The frequency of the voltage applied between the electrodes 2 and 3 was 5 kHz and the voltage was 12 kV peak-to-peak.

### List of the reference symbols used

1 electrode system
2 first electrically conductive electrodes
3 second electrically conductive electrodes
4 treated textile material
5 dielectric body
6 auxiliary electrode structure
7 pair of guide rolls
8 pair of guide rolls
9 upper wall
10 bottom wall
11 cooler
12 pair of internal guide rolls

## Claims

1. A method for treating woven and nonwoven textile materials, comprising a surface treatment of fibres which are situated inside of the textile materials or on the surface of the textile materials **characterised in that** the textile materials are affected by electrical plasma generated by electrical discharges initiated using an electrode system (1) comprising at least two electrically conductive electrodes (2,3) situated inside of a dielectric body (5) on the same side of the textile material (4) treated, wherein a voltage of a frequency from 50 Hz to 1 MHz and magnitude from 100 V to 100 kV is applied between the electrodes (2,3) of the electrode system, and the electrode system (1) is situated in a gas at a pressure from 1 kPa to 1000 kPa, wherein the electrical plasma is generated on a portion of the dielectric body (5) surface without a contact with the electrically conductive electrodes (2,3).

2. The method of Claim 1, **characterised in that** said treated material (4) is in contact with the surface of the dielectric body (5) in which the electrodes (2,3) are situated.

3. The method of Claim 1, **characterised in that** the electrical discharge initiation and the plasma generation is facilitated by an addition auxiliary electrode structure (6) which is a part of the electrode system (1) and is situated inside the dielectric body (5).

4. The method of Claim 3, **characterised in that** the electric voltage applied to the auxiliary electrode structure (6) is different from the voltage applied to the other electrically conductive electrodes (2,3) of the electrode system (1).

5. The method of Claim 1, **characterised in that** the textile material (4) is treated in the shape of a given planar pattern in contact with the plasma generated on the dielectric body surface under which the electrodes (2,3) are situated and which has the shape of the given pattern.

6. The method of Claims 1 and 2, **characterised in that** the treated textile material (4) is moved along the dielectric body (5) in which the electrodes (2,3) are situated.

7. The method of Claim 1, **characterised in that** the treated textile material (4) is moved between two electrode systems, where one electrode system (1)is situated on one side of the treated textile material (4) and the second electrical system (1) is situated on the opposite side of the treated textile material (4).

8. The method of Claim 1, **characterised in that** the treated textile material (4) is driven on the electrode system surface.

9. A textile treatment apparatus providing means for surface treatment of fibres of woven and nonwoven textile materials that are situated inside of the textile materials or on the surface of a textile materials **characterised in that** it contains an electrode system (1) comprising at least two electrically conductive electrodes (2,3) situated inside of a dielectric body (5) on the same side of the textile material treated (4), wherein a voltage of a frequency from 50 Hz to 1 MHz and magnitude from 100 V to 100 kV is applied between the electrodes (2,3) of the electrode system (1), and the electrode system (1) is situated in a gas at a pressure from 1 kPa to 1000 kPa, wherein the electrical plasma is generated on a portion of the dielectric body (5) surface without a contact with the electrically conductive electrodes (2,3).

10. The apparatus of Claim 9, **characterised in that** the electrically conductive electrodes (2, 3) are parallel with the portion of the surface of the dielectric body (5) on which the electrical plasma is generated.

11. The apparatus of Claim 9, wherein the portion of the dielectric body (5) surface under which the electrodes (2,3) are situated has the shape of a given pattern.

12. The apparatus of Claim 9 **characterised in that** it comprises further an auxiliary electrode structure (6) which is also situated inside the dielectric body (5).

13. The apparatus of Claim 9, **characterised in that** it contains two electrode systems (1) situated on both sides of the textile material (4) affected by the plasma, each of said electrode systems (1) comprising electrically conductive electrodes (2,3) which are situated inside said dielectric body (5) wherein a voltage of a frequency from 50 Hz to 1 MHz and magnitude from 100 V to 100 kv is applied between the electrodes (2,3) of each electrode system (1).

14. The apparatus of Claim 9, **characterised in that** a portion of the electrode system (1) has the shape of a plane surface, curved surface, or cylindrical surface.

15. The apparatus of Claim 9, **characterised in that** a part of the dielectric body. (5) is made from a ferroelectric material.

16. The apparatus of Claim 9, **characterised in that** a part of the dielectric body (5) is made from a liquid dielectric material.

17. The apparatus of Claim 9, **characterised in that** the edges of the electrically conductive electrodes (2,3) are curved.

18. The apparatus of Claim 9, **characterised in that** a part of the dielectric body (5) contains MgO.

19. The apparatus of Claim 12, **characterised in that** the edges of the electrodes of the auxiliary electrode structure (6) are curved.

## Patentansprüche

1. Methode zur Bearbeitung von gewebten und ungewebten Textilien, die sich aus der Oberflächenbehandlung der Fasern zusammensetzt, die sich im Inneren der Textilien oder auf ihrer Oberfläche befinden, die **dadurch** charakterisiert wird, dass die Textilien der Wirkung von Plasma ausgesetzt sind, das durch elektrische Entladungen entsteht, die durch Verwendung eines Elektrodensystems (1) hervorgerufen werden, das sich aus wenigstens zwei elektrisch leitenden Elektroden (2,3) zusammensetzt, die sich im Inneren der dielektrischen Anlage (5) auf der gleichen Seite der bearbeiteten Textilien (4) befinden, in der zwischen den Elektroden (2,3) im System eine Spannung mit einer Frequenz zwischen 50 Hz und 1 MHz und einer Größe zwischen 100 V und 100 kV wirkt, und das Elektrodensystem (1) befindet sich in einem gasförmigen Umfeld mit einem Druck zwischen 1 kPa und 1000 kPa, in dem auf einem Teil der Oberfläche der dielektrischen Anlage (5) eine Plasmaentladung ohne Kontakt mit den leitenden Elektroden (2,3) entsteht.

2. Die in Anforderung 1 aufgeführte Methode, die **dadurch** charakterisiert wird, dass die genannten bearbeiteten Textilien (4) in Kontakt mit der Oberfläche der dielektrischen Anlage (5) sind, in der sich die Elektroden (2,3) befinden.

3. Die in Anforderung 1 aufgeführte Methode, die **dadurch** charakterisiert wird, dass das Entstehen der elektrischen Entladungen und des Plasmas vereinfacht wird, indem eine Hilfselektrodenstruktur(6) hinzugefügt wird, die Bestandteil des Elektrodensystems (1) ist und die sich im Inneren der dielektrischen Anlage (5) befindet.

4. Die in Anforderung 3 aufgeführte Methode, die **dadurch** charakterisiert wird, dass die elektrische Spannung, die auf die Hilfselektrodenstruktur (6) wirkt, sich von der Spannung unterscheidet, die auf die übrigen leitenden Elektroden (2, 3) des Elektrodensystems (1) wirkt.

5. Die in Anforderung 1 aufgeführte Methode, die **dadurch** charakterisiert wird, dass die Textilien (4) in der Form der betreffenden ebenen Schablone in Kontakt mit dem Plasma bearbeitet werden, das auf der Oberfläche der dielektrischen Anlage entsteht, unter der sich die Elektroden (2,3) befinden und die die Form der betreffenden Schablone hat.

6. Die in den Anforderungen 1 und 2 aufgeführte Methode, die **dadurch** charakterisiert wird, dass die bearbeiteten Textilien (4) sich entlang der dielektrischen Anlage (5) bewegen, in der sich die Elektroden (2,3) befinden.

7. Die in Anforderung 1 aufgeführte Methode, die **dadurch** charakterisiert wird, dass die bearbeiteten Textilien (4) sich zwischen zwei Elektrodensystemen bewegen, von denen ein Elektrodensystem (1) sich auf einer Seite der bearbeiteten Textilien (4) befindet und das andere elektrische System (1) sich auf der entgegengesetzten Seite der bearbeiteten Textilien befindet.

8. Die in Anforderung 1 aufgeführte Methode, die **dadurch** charakterisiert wird, dass die bearbeiteten Textilien (4) über die Oberfläche des Elektrodensystems geführt werden.

9. Apparatur für die Bearbeitung von Textilien, die die Oberflächenbehandlung der Fasern gewebter und ungewebter Textilien ermöglicht, die sich im Inneren der Textilien oder auf ihrer Oberfläche befinden, die **dadurch** charakterisiert wird, dass sie sich aus einem Elektrodensystem (1) zusammensetzt, das wenigstens zwei elektrisch leitende Elektroden (2,3) enthält, die sich im Inneren der dielektrischen Anlage (5) auf der gleichen Seite der bearbeiteten Textilien (4) befinden, in der zwischen den Elektroden (2,3) im Elektrodensystem (1) eine Spannung mit einer Frequenz zwischen 50 Hz und 1 MHz und einer Größe zwischen 100 V bis 100 kV wirkt, und das Elektrodensystem (1) befindet sich in einem gasförmigen Umfeld mit einem Druck zwischen 1 kPa und 1000 kPa, in dem auf einem Teil der Oberfläche der dielektrischen Anlage (5) eine Plasmaentladung ohne Kontakt mit den leitenden Elektroden entsteht (2,3).

10. Die in Anforderung 9 aufgeführte Apparatur, die **dadurch** charakterisiert wird, dass die leitenden Elektroden (2,3) sich parallel zu einem Teil der Oberfläche der dielektrischen Anlage (5) befinden, auf der die Plasmaentladungen entstehen.

11. Die in Anforderung 9 aufgeführte Apparatur, in der ein Teil der Oberfläche der dielektrischen Anlage, unter der sich die Elektroden (2,3) befinden, die Form der betreffenden Schablone hat.

12. Die in Anforderung 9 aufgeführte Apparatur, die **dadurch** charakterisiert wird, dass sie darüber hinaus eine Hilfselektrodenstruktur (6) enthält, die sich gleichfalls im Inneren der dielektrischen Anlage (5) befindet.

13. Die in Anforderung 9 aufgeführte Apparatur, die **dadurch** charakterisiert wird, dass sie zwei Elektrodensysteme (1) enthält, die sich auf beiden Seiten der dem Wirken des Plasmas ausgesetzten Textilien (4) befinden, wobei jedes der genannten Elektrodensysteme (1) sich aus elektrisch leitenden Elektroden (2,3) zusammensetzt, die sich im Inneren der erwähnten dielektrischen Anlage (5) befinden, in der zwischen den Elektroden (2,3) jedes Elektrodensystems (1) eine Spannung mit einer Frequenz zwischen 50 Hz und 1 MHz und einer Größe zwischen 100 V und 100 kV wirkt.

14. Die in Anforderung 9 aufgeführte Apparatur, die **dadurch** charakterisiert wird, dass ein Teil des Elektrodensystems (1) die Form einer ebenen Fläche, einer gewölbten Fläche oder einer zylindrischen Fläche hat.

15. Die in Anforderung 9 aufgeführte Apparatur, die **dadurch** charakterisiert wird, dass ein Teil der dielektrischen Anlage (5) aus ferroelektrischem Material hergestellt ist.

16. Die in Anforderung 9 aufgeführte Apparatur, die **dadurch** charakterisiert wird, dass ein Teil der dielektrischen Anlage (5) aus flüssigem, dielektrischem Material hergestellt ist.

17. Die in Anforderung 9 aufgeführte Apparatur, die **dadurch** charakterisiert wird, dass die Kanten der leitenden Elektroden (2,3) abgerundet sind.

18. Die in Anforderung 9 aufgeführte Apparatur, die **dadurch** charakterisiert wird, dass ein Teil der dielektrischen Anlage (5) MgO enthält.

19. Die in Anforderung 12 aufgeführte Apparatur, die **dadurch** charakterisiert wird, dass die Kanten der Elektroden der Hilfselektrodenstruktur (6) abgerundet sind.

## Revendications

1. Une méthode de traitement des matériaux textiles tissés et non tissés, comprenant un traitement en surface des fibres qui se trouvent à l'intérieur des matériaux textiles ou sur la surface des matériaux textiles, **caractérisés par le fait que** les matériaux textiles sont affectés par le plasma électrique généré par les décharges électriques ayant été initiées en faisant appel à l'utilisation d'un système d'électrodes(1) comprenant au moins deux électrodes conductrices d'électricité (2,3) situées à l'intérieur d'un corps diélectrique (5) du même côté que le matériel textile traité (4), dans lequel une tension d'une fréquence comprise entre 50 Hz et 1 MHz ainsi qu'une ampleur allant de 100 V à 100 kV est appliquée entre les électrodes (2,3) du système d'électrodes, et le système d'électrodes (1) est immergé dans un gaz ayant une pression comprise entre 1 kPa et 1000 kPa, dans lequel le plasma électrique est généré sur une partie de la surface du corps diélectrique (5) sans aucun contact avec les électrodes conductrices d'électricité (2,3).

2. La méthode Claim 1, **caractérisée par le fait que** le matériel traité mentionné (4) est en contact avec la surface du corps diélectrique (5) dans lequel les électrodes (2,3) sont situées.

3. La méthode Claim 1, **caractérisée par le fait que** l'initiation de la décharge électrique et la génération de plasma est facilitée par une structure auxiliaire d'électrodes complémentaire (6) qui fait partie du système d'électrodes (1) et qui se trouve à l'intérieur du corps diélectrique (5).

4. La méthode Claim 3, **caractérisée par le fait que** la tension électrique appliquée à la structure auxiliaire d'électrodes (6) est différente de la tension appliquée aux autres électrodes conductrices d'électricité (2,3) du système d'électrodes (1).

5. La méthode Claim 1, **caractérisée par le fait que** le matériel textile (4) est traité sous la forme d'un motif plénaire donné en contact avec le plasma généré sur la surface du corps diélectrique sous lequel les électrodes (2,3) sont situées et qui a la forme du motif donné.

6. Les méthodes Claims 1 et 2, **caractérisées par le fait que** le matériel textile traité (4) est déplacé le long du corps diélectrique (5) dans lequel les électrodes (2,3) se trouvent.

7. La méthode Claim 1, **caractérisée par le fait que** le matériel textile traité (4) est déplacé entre deux systèmes d'électrodes, où l'un des systèmes d'électrodes (1)se trouve d'un côté du matériel textile traité (4) et le deuxième système électrique (1) se trouve du côté opposé au matériel textile traité (4).

8. La méthode Claim 1, **caractérisée par le fait que** le matériel textile traité (4) soit conduit sur la surface du système d'électrodes.

9. Un dispositif de traitement de surface fournissant les moyens pour un traitement des fibres en surface de matériaux textiles tissés et non tissés qui se situent à l'intérieur des matériaux textiles ou sur la surface de matériaux textiles, **caractérisé par le fait qu'**il contient un système d'électrodes (1) comprenant au moins deux électrodes conductrices d'électricité (2,3) situées à l'intérieur d'un corps diélectrique (5) du même côté que le matériel textile traité (4), dans lequel une tension d'une fréquence allant de 50 Hz à 1 MHz et une ampleur de 100 V à 100 kV est appliquée entre les électrodes (2,3) du système d'électrodes (1), et le système d'électrodes (1) est situé dans un gaz à une pression comprise entre 1 kPa et 1000 kPa, dans lequel le plasma électrique est généré sur une partie de la surface du corps diélectrique (5) sans aucun contact avec les électrodes conductrices d'électricité (2,3).

10. Le dispositif Claim 9, **caractérisé par le fait que** les électrodes conductrices d'électricité (2,3) sont parallèles avec la partie de surface du corps diélectrique (5) sur lequel le plasma électrique est généré.

11. Le dispositif Claim 9, dans lequel la partie de la surface du corps diélectrique (5) sous lequel les électrodes (2,3) sont situées, a la forme d'un motif donné.

12. Le dispositif Claim 9, **caractérisé par le fait qu'**il comprend une structure auxiliaire d'électrodes (6) qui est également située à l'intérieur du corps diélectrique (5).

13. Le dispositif Claim 9, **caractérisé par le fait qu'**il contient deux systèmes d'électrodes (1) situés des deux côtés du matériel textile (4) affecté par le plasma, chacun des systèmes d'électrodes mentionnés (1) comprenant des électrodes conductrices d'électricité (2,3) qui se situent à l'intérieur du corps diélectrique mentionné (5) dans lequel une tension d'une fréquence allant de 50 Hz à 1 MHz et une ampleur comprise entre 100 V et 100 kV sont appliqués entre les électrodes (2,3) de chaque système d'électrodes (1).

14. Le dispositif Claim 9, **caractérisé par le fait qu'**une partie du système d'électrodes (1) à la forme d'une surface plane, courbée ou cylindrique.

15. Le dispositif Claim 9, **caractérisé par le fait qu'**une partie du corps diélectrique (5) est fabriquée à partir d'un matériel ferroélectrique.

16. Le dispositif Claim 9, **caractérisé par le fait qu'**une partie du corps diélectrique (5) est fabriquée à partir d'un matériel diélectrique liquide.

17. Le dispositif Claim 9, **caractérisé par le fait que** les bords des électrodes conductrices d'électricité (2,3) sont courbées.

18. Le dispositif Claim 9, **caractérisé par le fait qu'**une partie du corps diélectrique (5) contient du MgO.

19. Le dispositif Claim 12, **caractérisé par le fait que** les bords des électrodes de la structure auxiliaire d'électrodes (6) sont courbées.
